# EUROPEAN PATENT SPECIFICATION

(11) **EP 4 267 668 B1**
(45) Date of publication and mention of the grant of the patent: **01.01.2025**
(21) Application number: 21836453.7
(22) Date of filing: 10.12.2021
(51) Int. Cl.: C08K 3/04, C08K 9/08, C08L 67/02, C08J 5/04

(54) **POLYBUTYLENE TEREPHTHALATE COMPOSITION AND ARTICLE**
POLYBUTYLENTEREPHTHALATZUSAMMENSETZUNG UND ARTIKEL
COMPOSITION DE TÉRÉPHTALATE DE POLYBUTYLÈNE ET ARTICLE

(30) Priority: 28.12.2020 WO PCT/CN2020/140175
(43) Date of publication of application: 01.11.2023
(73) Proprietor: BASF SE, 67056 Ludwigshafen am Rhein (DE)
(72) Inventor: HE, Li Rong, Shanghai 200439 (CN); LIU, Tao, Shanghai 200137 (CN); WANG, Li Xia, Shanghai 200137 (CN); WEI, Zhen Ke, Shanghai 200137 (CN)
(74) Representative: BASF IP Association
(86) International application number: PCT/EP2021/085224
(87) International publication number: WO 2022/144159

(56) References cited:
- CN-A- 108 570 223
- US-A1- 2015 183 984
- US-B2- 10 793 698

## Description

### FIELD OF THE INVENTION

The present invention relates to a polybutylene terephthalate (PBT) composition, and an article produced from the same.

### BACKGROUND OF THE INVENTION

In recent decades, electronic devices played an increasingly essential role in various fields and the amounts thereof increased dramatically. Electromagnetic interference (EMI) has always been a problem accompanying the electronic devices. In order to prevent or reduce harmful influence of the electromagnetic interference between different electronic parts in an electronic device or between an electronic device with environments, a housing is generally used as a barrier. In certain fields, the housing is made of plastic composite materials, for example filled plastic composite materials. Typically, the filled plastic composite materials consist of a thermoplastic polymer matrix, an electromagnetic absorbing filler, and optionally additional additives.

A variety of thermoplastic polymers may be used as the matrix of the filled plastic shielding composite materials depending on the particular application fields, for example polyesters such as polyethylene terephthalate (PET) and polybutylene terephthalate (PBT), polycarbonates, copolyester-carbonates, polyarylene ether sulfones and ketones, polyamides, polyamide-imides, polystyrenes, acrylonitrile-butadiene styrene copolymers, polyetherimides and polyphenylene ethers.

Electromagnetic absorbing filler useful in the filled plastic shielding composite materials are desirably electrically conductive. Metal powders were initially used as the electromagnetic absorbing filler. With the developments of the filled plastic shielding composite materials, carbon materials such as carbon black, graphite, carbon fiber and carbon nanotube have been proposed, among which carbon fiber is a good candidate due to its excellent overall performance with respect to electromagnetic shielding efficacy, electric conductivity, thermal conductivity and the mechanical property.

For example, WO2019088062A1 describes an electromagnetic shielding/absorbing molded article which comprises a thermoplastic resin composition comprising a thermoplastic resin and carbon fibres. The carbon fibers have a weight-average fiber length in the molded body in the range of 0.05 to 8.0 mm and present in the molded body at a content of 0.05 to 45wt%. The thermoplastic resin may be selected from polypropylene, copolymers containing propylene units and modified products thereof, styrenic resins, polyphenylene sulfide, polyamide, polyethylene terephthalate, polybutylene terephthalate and polycarbonate. JP2014133842A describes an electromagnetic shielding conductive resin composition comprising a thermoplastic resin and carbon nanotubes, carbon black and carbon fibers, and having a volume resistivity of 1 × 10 ² Ω · cm or less. The thermoplastic resin may be olefin resins, acrylic resins, styrene resins, vinyl resins, polyesters, polyamides, polyimides, polyetherimide, polycarbonate, polyacetal, polyethersulfone, polyphenylene oxide, polyphenylene sulfide, polysulfone, polyurethane, etc.

CN104004355A describes an EMI shielding thermoplastic resin composition comprising (A) a thermoplastic resin, (B) carbon fibers, and (C) a filler. The thermoplastic resin (A) may comprise polyphenylene sulfide, polyamide, polyalkylene terephthalate, polyacetal, polyimide, polyphenylene oxide, polysulphone, polyamideimide, polyethersulfone, liquid crystalline polymer, polyetherketone, polyetherimide, polyolefin, acrylonitrile-butadienestyrene copolymer, polystyrene, or a combination thereof.

CN1 08570223A discloses a thermoplastic composition comprising 60 to 80 % by weight of a thermoplastic matrix resin and 20 to 40 % by weight of a filler including carbon fibers coated with a sizing agent.

There is a continuing need to provide filled plastic composite materials having desirable electromagnetic shielding effectiveness and the balance of mechanical properties especially in the radome application.

### SUMMARY OF THE INVENTION

The object of the present invention is to provide an electromagnetic interference (EMI) shielding polybutylene terephthalate (PBT) composition, which has an improved electromagnetic shielding effectiveness and electrical conductivity, particularly without substantial compensate of thermal conductivity and mechanical property.

The object of the present invention has been achieved by a polybutylene terephthalate (PBT) composition comprising a particular carbon fiber as the electromagnetic absorbing filler.

Accordingly, the present invention provides a polybutylene terephthalate composition, comprising
(A) 45 to 75 % by weight of polybutylene terephthalate,
(B) 20 to 45 % by weight of at least one carbon fiber,
(C) 0 to 20 % by weight of at least one solid filler other than the carbon fiber (B), and
(D) 0 to 30 % by weight of at least one thermoplastic polyester other than polybutylene
terephthalate,
each being based on the total weight of the polybutylene terephthalate composition, wherein the at least one carbon fiber has a carbon content of 93% by weight or greater, and comprises a sizing agent other than epoxy sizing agent.

The present invention also provides an EMI shielding article produced from the polybutylene terephthalate composition as described herein.

The present invention further provides use of a carbon fiber having a carbon content of 93% by weight or greater and comprising a sizing agent other than epoxy sizing agent.

It has been surprisingly found that the carbon fiber as described herein is particularly useful as the electromagnetic absorbing filler in an EMI shielding PBT composition. Articles having improved electromagnetic shielding effectiveness and electrical conductivity have been produced from the EMI shielding PBT composition according to the present invention.

### DETAILED DESCRIPTION OF THE INVENTION

The present invention will be described in detail hereinafter. It is to be understood that the present invention may be embodied in many different ways and shall not be construed as limited to the embodiments set forth herein.

The singular forms "a", "an" and "the" include plural referents unless the context clearly dictates otherwise. The terms "comprise", "comprising", etc. are used interchangeably with "contain", "containing", etc. and are to be interpreted in a non-limiting, open manner. That is, e.g., further components or elements may be present. The expressions "consists of" or "consists essentially of" or cognates may be embraced within "comprises" or cognates.

The terms "polybutylene terephthalate" and "polybutylene terephthalate composition" herein may also be referred to as "PBT" and "PBT composition" as abbreviations respectively.

### Component (A)

PBT is known as a crystalline or semicrystalline thermoplastic polymeric material, for example derived from polycondensation of 1,4-butanediol with terephthalic acid via esterification or with an ester of terephthalic acid via transesterification.

There is no particular restriction to the PBT useful in the polybutylene terephthalate composition according to the present invention. Generally, suitable PBTs may have a weight average molecular weight (M_{w}) of from 60,000 to 100,000 as measured by gel permeation chromatography. Additionally or alternatively, suitable PBTs may have a viscosity number in the range from 90 to 170 cm³/g, preferably from 100 to 135 cm³/g, more preferably from 100 to 120 cm³/g, as measured in a 0.005g/ml phenol/1,2-dichlorobenzene solution (1:1 mass ratio), according to ISO 1628-5.

Any PBTs prepared via known processes or any commercially available PBT materials suitable as engineering plastics may be used for the purpose of the present invention. Examples of commercially available PBT materials include, but are not limited to, Ultradur^{®} series from BASF, BLUESTAR^{®} series from Bluestar, Crastin^{®} series from DuPont, Pocan^{®} series from Lanxess, NOVADURAN^{®} series from Mitsubishi, LNP^{™} LUBRICOMP^{™} series and VALOX^{™} series from SABIC, RAMSTER^{®} series from Polyram, and Toraycon^{®} series from Toray.

It is preferred that the component (A) is present in the PBT composition according to the present invention in an amount of 50 to 75 % by weight, for example 50 to 70 % by weight, particularly 50 to 65 % by weight, based on the total weight of the PBT composition.

It is to be understood that the amount of the component (A) when mentioned herein is intended to refer to the amount of PBT *per se.* Commercially available PBT materials often have been already intentionally added with certain additive(s) to provide one or more desired properties such as color, strength, stability and the like, which additive(s) will not be accounted in the amount of the component (A).

### Component (B)

For the purpose of the present invention, suitable carbon fibers may be those produced by a process including steps:
(1) carbonation of a precursor fiber to produce a fiber having a carbon content of 93% by weight or greater, and
(2) treatment of the fiber with a sizing composition comprising no epoxy sizing agent.

Suitable carbon fibers as the component (B) may have a mean diameter of 5 to 30 µm, preferably 5 to 20 µm, more preferably 5 to 15 µm, and a length of 3 to 20 mm, preferably 3 to 15 mm, more preferably 5 to 10 mm. It is preferred that the carbon fibers suitable as the component (B) have an aspect ratio of 270 to 4,000 (i.e., length/diameter ratio), particularly 400 to 2000.

Suitable carbon fibers as the component (B) may have a density of 1.7 to 1.8 g/cm³. Additionally or alternatively, The carbon fibers may have a tensile strength of 3.4 to 5.0 GPa, particularly 3.4 to 4.6 GPa, as measured according to TY-030-B-01.

Conventionally, the process of production of a carbon fiber may further comprise one or more steps of processing and/or pretreating the precursor fiber before the carbonation step. There is no particular restriction to the processing and/or pretreating step(s) in the process of production of the carbon fibers useful in the present invention.

The precursor fiber may be selected from spun fibers of polyacrylonitrile (PAN), pitch or rayon type. The carbon fibers obtained from those precursors are generally referred to as polyacrylonitrile-based carbon fibers (PAN-based carbon fibers), pitch-based carbon fibers or rayon-based carbon fibers. Particularly, spun fibers of polyacrylonitrile are suitable as the precursor fiber for the purpose of the present invention, and thus polyacrylonitrile-based carbon fibers are particularly useful for the component (B).

The carbonation of precursor fiber in step (1) may be carried out at a temperature of 1300°C or lower, preferably in the range of 1100 to 1300 °C, for example 1100 °C, 1200 °C and1300 °C.

It is preferred that the fiber obtained from the carbonation of precursor fiber in step (1) has a carbon content of 93% by weight or greater, for example, 93% by weight, 94% by weight, 95% by weight. The carbon contents of the fiber in the range of 93% by weight to 95% by weight may be contemplated for the purpose of the present invention. The carbon content may be measured via element analysis and determined by the ratio of the carbon weight to the sample weight, for example according to GBT 26752-2011. There is no difference in results between various element analysis method.

It is to be understood that the "carbon content", when mentioned for the component (B), refers to the carbon content of the carbon fibers before sizing.

For the treatment of the fiber in step (2), the sizing composition may comprise any sizing agents other than epoxy sizing agent. As the sizing agent for the carbon fibers useful for the present invention, polyurethane resins (PU) and/or polyester resins may be particularly mentioned. More preferably, a thermosetting polyester resin is used as the sizing agent.

Accordingly, the carbon fibers useful as the component (B) comprises a sizing agent selected from polyurethane resins and polyester resins, particularly thermosetting polyester resins.

The sizing composition is generally in form of dispersion, particularly water dispersion of the sizing agent, which may also comprise one or surfactant or any other aids. The sizing agent may be present in the sizing composition in any conventional amounts, for example in an amount of 1-4 % by weight of the carbon fiber.

It is preferred that the component (B) is present in the PBT composition according to the present invention in an amount of 20 to 40 % by weight, particularly 25 to 40 % by weight, based on the total weight of the PBT composition.

### Component (C)

The PBT composition according to the present invention may comprise 0 to 20 % by weight of at least one solid filler other than the carbon fiber (B). The solid filler may for example be carbonaceous or metallic filler. Suitable carbonaceous fillers may include, but are not limited to carbon black powders and flakes, graphite powders and flakes, carbon nanotubes, and carbon fibers other than the carbon fiber (B). Suitable metallic fillers may be selected from platinum group metal such as palladium (Pd) and platinum (Pt), transition metal such as cobalt, iron, nickel, silver, tin, copper, and any combinations thereof. Particularly, the component (C) may comprise carbon black powders or flakes. It is preferred that graphite powders or flakes alone will not constitute the solid filler as the component (C), more preferred that mixture of graphite and carbon black is used as component (C).

It is preferred that the component (C), if comprised, is present in the PBT composition according to the present invention in an amount of 0.1 to 20 % by weight, particularly 1 to 20 % by weight, preferably 5 to 20 %, based on the total weight the PBT composition.

### Component (D)

The PBT composition according to the present invention may optionally comprise one or more thermoplastic polyesters other than PBT.

The polyesters are generally derived from at least one glycol with at least one dicarboxylic acid or reactive equivalents thereof. The at least one glycol may be aliphatic, aromatic or in combination. The at least one dicarboxylic acid may be aromatic, cycloaliphatic dicarboxylic or in combination.

Examples of suitable aliphatic glycols include, but are not limited to, straight chain, branched, or cycloaliphatic alkylene glycols, such as ethylene glycol, 1,2-propylene glycol, 1,3-propylene glycol, 2-methyl-1,3-propandiol, 2,2-dimethyl-1,3-propane diol, 2-ethyl-2-methyl-1,3-propane diol, 1,3-pentane diol, 1,5-pentane diol, 2-methyl-1,5-pentane diol, 1,6-hexane diol, 1,4-cyclohexane dimethanol, triethylene glycol, dipropylene glycol and 1,10-decanediol. Examples of suitable aromatic glycols include, but are not limited to, resorcinol, hydroquinone, pyrocatechol, 1,5-naphthalene diol, 2,6-naphthalene diol, 1,4-naphthalene diol, 4,4' - dihydroxybiphenyl, bis(4-hydroxyphenyl)ether and bis(4-hydroxyphenyl)sulfone.

Examples of suitable aromatic dicarboxylic acids include, but are not limited to, terephthalic acid, phthalic acid, isophthalic acid, 1,4-naphthalenedicarboxylic acid, 1,5-naphthalene dicarboxylic acid, 2,6-naphthalene dicarboxylic acid. Examples of suitable cycloaliphatic dicarboxylic acids include, but are not limited to, norbornene dicarboxylic acid and 1,4-cyclohexane dicarboxylic acid. Suitable equivalents of dicarboxylic acids may include, but are not limited to, dialkyl or diaryl esters of dicarboxylic acids, for example dimethyl esters, anhydrides, salts and acid chlorides.

As the component (D), particularly useful polyesters may include polyalkylene terephthalates other than PBT such as polyethylene terephthalate (PET) and polytrimethylene terephthalate (PTT), polyalkylene naphthoates such as polyethylene naphthanoate (PEN) and polybutylene naphthanoate (PBN), , polycycloalkylene terephthalates such as polycyclohexanedimethylene terephthalate (PCT). Preferably PET and PTT, especially PET may be used as the component (D).

The component (D), when present, may be in an amount of about 1 to about 30% by weight, for example about 5 to about 30% by weight, or about 5 to about 20% by weight, based on the total weight of the PBT composition.

### Component (E)

The PBT composition according to the present invention may further comprise one or more additives (E), for example release agents, impact modifier, thermostabilizers, compatibilizing agents, stabilizers, lubricants, reinforcing agents, antioxidants, photostabilizers, plasticizers, colorants such as dyes and/or pigments, surfactants, nucleating agents, coupling agents, antimicrobial agents, antistatic agents, and the like. The additives may be used in conventional amounts. For example, the PBT composition may include one or more additives in an amount of 0.01 to 15% by weight based on the total weight of the PBT composition.

The PBT composition may for example comprise an impact modifier. Suitable impact modifiers may include polyolefin-based, styrene-based, unsaturated carboxylic acid-based impact modifiers. Suitable impact modifiers can also be those modified by a functional block, such as epoxy functional block and/or acid anhydride block. The epoxy function block could be units derived from a glycidyl (meth)acrylate. The acid anhydride block could be units derived from maleic anhydride.

Suitable polyolefin-based impact modifiers may include polyolefins comprising repeating units derived from olefin having 2 to 10 carbon atoms. Examples of such olefins include ethylene, 1-butene, 1-propylene, 1-pentene, 1-octene and mixture of ethylene and 1-octene, preferably ethylene, 1-propylene and mixture of ethylene and 1-octene.

Suitable unsaturated carboxylic acid-based impact modifiers may include blocks derived from carboxylic acid and derivates thereof such as ester, imide and amide. Suitable carboxylic acid and derivates thereof are for example acrylic acid, acrylic acid, methacrylic acid, maleic acid, fumaric acid, glutaconic acid, itaconic acid, citraconic acid, (meth)acrylate, methyl (meth)acrylate, ethyl (meth)acrylate, propyl (meth)acrylate, butyl (methyl)acrylate and isobutyl (meth)acrylate.

The impact modifier may also be a bi- or ter-polymer or a core-shell structure polymer. Examples of such impact modifier include styrene/ethylene/butylene copolymer (SEBS), ethylene-methyl acrylate-glycidyl methacrylate terpolymer, ethylene/propylene/diene rubber (EPDM) and ethylene-octene copolymer.

The impact modifier, when present, may be in an amount of about 0.01 to about 15% by weight, or about 1 to about 15% by weight, or about 5 to about 10% by weight, based on the total weight of the PBT composition.

The PBT composition may for example comprise a lubricant or a processing aid. Suitable lubricant or processing agent is preferably an ester or amide of saturated aliphatic carboxylic acids having from 10 to 40 carbon atoms and/or saturated aliphatic alcohols or amines having from 2 to 40 carbon atoms. The lubricant is preferably pentaerythritol esters of fatty acid having10 to 20 carbon atoms, more preferably pentaerythritol tetrastearate.

The lubricant, when present, may be in an amount of 0 to about 3% by weight, or about 0.01 to about 2 % by weight, or about 0.2 to about 1 % by weight, based on the total weight of the PBT composition.

The PBT composition may for example comprise an antioxidant. Suitable antioxidants are aromatic amine-based antioxidants, hindered phenol-based antioxidants and phosphite-based antioxidants, particularly hindered phenol-based antioxidants. Examples of hindered phenol-based antioxidants include α-[3-[3,5-bis(1,1-dimethylethyl)-4-hydroxyphenyl]-1-oxopropyl]-w-[3-[3,5-bis(1,1-dimethylethyl)-4-hydroxyphenyl]-1-oxopropoxy]poly(oxy-1,2-ethanediyl), 2,4-bis[(octylthio)methyl]-o-cresol, octyl-3,5-di-tert-butyl-4-hydroxyhydrocinnamate, 3,5-bis(1,1-dimethylethyl)-4-hydroxybenzenepropanoic acid C₇-C₉-branched alkyl ester, 2,4-bis[(dodecylthio)methyl]-o-cresol, 4,4'-butylidene bis-(3-methyl-6-tert-butylphenol), 3,5-bis(1,1-dimethylethyl)-4-hydroxybenzenepropanoic acid octadecyl ester, pentaerythritol tetrakis(3-(3,5-di-tert-butyl-4-hydroxyphenyl)propionate), triethylene glycol bis[3-(3-tert-butyl-5-methyl-4-hydrophenyl)propionate], 2,4-bis(n-octylthio)-6-(4-hydroxy-3,5-di-tert-butylanilino)-1,3,5-triazine, tris-(3,5-di-tert-butyl-4-hydroxybenzyl)isocyanurate, 2,2-thiodiethylene bis[3-(3,5-di-tert-butyl-4-hydroxyphenyl)propionate].

The antioxidant, when present, may be in an amount of 0 to about 2% by weight, or about 0.01 to about 1% by weight, or about 0.2 to about 0.8% by weight, based on the total weight of the PBT composition.

The PBT composition may for example comprise an adhesive adjuvant. Suitable adhesive adjuvants may be epoxides, for example epoxidized alkyl esters of fatty acid such as epoxidized linseed oil, epoxidized soybean oil and epoxidized rapeseed oil, and epoxy resins such as bisphenol-A resin.

The adhesive adjuvant, when present, may be in an amount of 0 to about 2% by weight, or about 0.01 to about 1% by weight, or about 0.2 to about 0.8% by weight, based on the total weight of the PBT composition.

In one preferred embodiment, the PBT composition comprises:
(A) 45 to 75 % by weight of polybutylene terephthalate,
(B) 20 to 45 % by weight of at least one carbon fiber,
(C) 0 to 20 % by weight of at least one solid filler other than the carbon fiber (B), and
(D) 0 to 30 % by weight of at least one thermoplastic polyester other than polybutylene terephthalate,
(E) 0.1 to 2 % by weight of at least one antioxidant, 0.1 to 3 % by weight of at least one lubricant, 0.01 to 15 % by weight of at least one impact modifier;
each being based on the total weight of the polybutylene terephthalate composition, wherein the at least one carbon fiber has a carbon content of 93% by weight or greater, and comprises a sizing agent other than epoxy sizing agent.

### EMI Shielding Articles

The PBT composition according to the present invention may be processed into various structures or forms by conventional methods to provide EMI shielding articles. For example, the PBT (A), the carbon fiber (B), the solid filler (C), optionally the polyester other than PBT (D) and additives (E) may be mixed and then molded, for example via injection and/or extrusion to form an EMI shielding article.

It will be understood that all components of the PBT composition may be mixed at the same time. Alternatively, some components of the PBT composition may be pre-mixed and then mixed with other components.

It will also be understood that the additives may be incorporated as a separate component. Alternatively, in some cases that a commercially available PBT material already comprises some additives, such additives will be incorporated along with the PBT (A). It may also be possible that the one or more additives are incorporated via both routes.

Accordingly, the present invention provides an EMI shielding article produced from the PBT composition according to the present invention. It has been surprisingly found that the EMI shielding article according to the present invention may have an EMI shielding effectiveness of 35 dB or greater at 1GHz. Particularly, the EMI shielding article according to the present invention may have an EMI shielding effectiveness of 35 dB to 60 dB, particularly 35 to 55 dB at 1GHz, for example 35, 36, 37, 38, 39, 40, 41, 42, 43, 44, 45, 46,47, 48, 49, 50, 51, 52, 53, 54, or 55 dB.

It is preferred that the EMI shielding article according to the present invention may have a surface resistivity of 1 to 10 Ohm/square (Ω/□).

The EMI shielding articles according to the present invention may be various electronic equipment components or housings. Examples include, but are not limited to radome, integrated circuit (IC) chip housing and camera sensor housing.

Therefore, the present invention also provides a radome component produced from the polybutylene terephthalate composition, wherein the radome is preferably vehicle radome.

### Embodiments

Various embodiments are listed below. It will be understood that the embodiments listed below may be combined with all aspects and other embodiments in accordance with the scope of the invention.
1. A polybutylene terephthalate composition, comprising
   (A) 45 to 75 % by weight of polybutylene terephthalate,
   (B) 20 to 45 % by weight of at least one carbon fiber,
   (C) 0 to 20 % by weight of at least one solid filler other than the carbon fiber (B), and
   (D) 0 to 30 % by weight of at least one thermoplastic polyester other than polybutylene terephthalate,
   each being based on the total weight of the polybutylene terephthalate composition, wherein the at least one carbon fiber has a carbon content of 93% by weight or greater, and comprises a sizing agent other than epoxy sizing agent.
2. The polybutylene terephthalate composition according to Embodiment 1, wherein the at least one carbon fiber is selected from polyacrylonitrile-based carbon fibers, pitch-based carbon fibers or rayon-based carbon fibers, particularly polyacrylonitrile-based carbon fibers.
3. The polybutylene terephthalate composition according to any of preceding Embodiments, wherein the at least one carbon fiber is produced via carbonation at a temperature of 1300 °C or lower, for example in the range of 1100 to 1300 °C.
4. The polybutylene terephthalate composition according to any of preceding Embodiments, wherein the at least one carbon fiber has a carbon content of in the range of 93 to 95% by weight.
5. The polybutylene terephthalate composition according to any of preceding Embodiments, wherein the sizing agent is selected from polyurethane resins and polyester resins, particularly thermosetting polyester resins.
6. The polybutylene terephthalate composition according to any of preceding Embodiments, wherein the at least one carbon fiber has a mean diameter of 5 to 30 µm, preferably 5 to 20 µm, more preferably 5 to 15 µm, and a length of 3 to 20 mm, preferably 3 to 15 mm, more preferably 5 to 10 mm.
7. The polybutylene terephthalate composition according to Embodiment 6, wherein the at least one carbon fiber has an aspect ratio of 270 to 4,000, particularly 400 to 2000.
8. The polybutylene terephthalate composition according to any of preceding Embodiments, wherein the at least one carbon fiber (B) is present in an amount of 20 to 40 % by weight, particularly 25 to 40 % by weight, based on the total weight of the polybutylene terephthalate composition.
9. The polybutylene terephthalate composition according to any of preceding Embodiments, wherein the polybutylene terephthalate (A) is present in an amount of 50 to 75 % by weight, for example 50 to 70% by weight, particularly 50 to 65 % by weight, based on the total weight of the polybutylene terephthalate composition.
10. The polybutylene terephthalate composition according to any of preceding Embodiments, wherein the solid filler (C) is carbonaceous or metallic, preferably carbonaceous.
11. The polybutylene terephthalate composition according to any of preceding Embodiments, wherein the solid filler (C) comprises carbon black powders or flakes.
12. The polybutylene terephthalate composition according to any of preceding Embodiments, wherein the solid filler (C) is present in an amount of 0.1 to 20 % by weight, particularly 1 to 20 % by weight, preferably 5 to 20 % by weight, based on the total weight of the polybutylene terephthalate composition.
13. An EMI shielding article produced from the polybutylene terephthalate composition according to any of Embodiments 1 to 12.
14. The EMI shielding article according to Embodiment 13, which is selected from radome, IC chip housing or camera sensor housing.
15. The EMI shielding article according to Embodiment 13 or 14, which has an EMI shielding effectiveness of 35 dB or greater at 1GHz, for example 35 dB to 60 dB, particularly 35 to 55 dB.
16. The EMI shielding article according to any of Embodiments 13 to 15, which has a surface resistivity of 1 to 10 Ω/□.
17. Use of a carbon fiber as defined in any of Embodiments 1 to 7 in an EMI shielding polybutylene terephthalate composition.

More particularly, the following embodiments are preferred.
1. A polybutylene terephthalate composition, comprising
   (A) 45 to 75 % by weight of polybutylene terephthalate,
   (B) 20 to 45 % by weight of at least one carbon fiber,
   (C) 0 to 20 % by weight of at least one solid filler other than the carbon fiber (B), and
   (D) 0 to 30 % by weight of at least one thermoplastic polyester other than polybutylene terephthalate,
   each being based on the total weight of the polybutylene terephthalate composition, wherein the at least one carbon fiber has a carbon content of 93% by weight or greater, and comprises a sizing agent other than epoxy sizing agent.
2. The polybutylene terephthalate composition according to Embodiment 1, wherein the at least one carbon fiber is selected from polyacrylonitrile-based carbon fibers, pitch-based carbon fibers or rayon-based carbon fibers, particularly polyacrylonitrile-based carbon fibers.
3. The polybutylene terephthalate composition according to Embodiment 2, wherein the at least one carbon fiber is selected from polyacrylonitrile-based carbon fibers.
4. The polybutylene terephthalate composition according to Embodiment 1, wherein the at least one carbon fiber is produced via carbonation at a temperature of 1300 °C or lower.
5. The polybutylene terephthalate composition according to Embodiment 2, wherein at least one carbon fiber is produced via carbonation at a temperature of 1300 °C or lower.
6. The polybutylene terephthalate composition according to Embodiment 3, wherein the at least one carbon fiber is produced via carbonation at a temperature of 1300 °C or lower.
7. The polybutylene terephthalate composition according to Embodiment 1, wherein the at least one carbon fiber is produced via carbonation at a temperature in the range of 1100 to 1300 °C.
8. The polybutylene terephthalate composition according to Embodiment 2, wherein the at least one carbon fiber is produced via carbonation at a temperature in the range of 1100 to 1300 °C.
9. The polybutylene terephthalate composition according to Embodiment 3, wherein the at least one carbon fiber is produced via carbonation at a temperature in the range of 1100 to 1300 °C.
10. The polybutylene terephthalate composition according to Embodiment 1, wherein the at least one carbon fiber has a carbon content in the range of 93 to 95% by weight.
11. The polybutylene terephthalate composition according to Embodiment 2, wherein the at least one carbon fiber has a carbon content in the range of 93 to 95% by weight.
12. The polybutylene terephthalate composition according to Embodiment 3, wherein the at least one carbon fiber has a carbon content in the range of 93 to 95% by weight.
13. The polybutylene terephthalate composition according to Embodiment 4, wherein the at least one carbon fiber has a carbon content in the range of 93 to 95% by weight.
14. The polybutylene terephthalate composition according to Embodiment 5, wherein the at least one carbon fiber has a carbon content in the range of 93 to 95% by weight.
15. The polybutylene terephthalate composition according to Embodiment 6, wherein the at least one carbon fiber has a carbon content in the range of 93 to 95% by weight.
16. The polybutylene terephthalate composition according to Embodiment 7, wherein the at least one carbon fiber has a carbon content in the range of 93 to 95% by weight.
17. The polybutylene terephthalate composition according to Embodiment 8, wherein the at least one carbon fiber has a carbon content in the range of 93 to 95% by weight.
18. The polybutylene terephthalate composition according to Embodiment 9, wherein the at least one carbon fiber has a carbon content in the range of 93 to 95% by weight.
19. The polybutylene terephthalate composition according to Embodiment 1, wherein the sizing agent is selected from polyurethane resins and polyester resins, particularly thermosetting polyester resins.
20. The polybutylene terephthalate composition according to Embodiment 2, wherein the sizing agent is selected from polyurethane resins and polyester resins, particularly thermosetting polyester resins.
21. The polybutylene terephthalate composition according to Embodiment 3, wherein the sizing agent is selected from polyurethane resins and polyester resins, particularly thermosetting polyester resins.
22. The polybutylene terephthalate composition according to Embodiment 4, wherein the sizing agent is selected from polyurethane resins and polyester resins, particularly thermosetting polyester resins.
23. The polybutylene terephthalate composition according to Embodiment 5, wherein the sizing agent is selected from polyurethane resins and polyester resins, particularly thermosetting polyester resins.
24. The polybutylene terephthalate composition according to Embodiment 6, wherein the sizing agent is selected from polyurethane resins and polyester resins, particularly thermosetting polyester resins.
25. The polybutylene terephthalate composition according to Embodiment 7, wherein the sizing agent is selected from polyurethane resins and polyester resins, particularly thermosetting polyester resins.
26. The polybutylene terephthalate composition according to Embodiment 8, wherein the sizing agent is selected from polyurethane resins and polyester resins, particularly thermosetting polyester resins.
27. The polybutylene terephthalate composition according to Embodiment 9, wherein the sizing agent is selected from polyurethane resins and polyester resins, particularly thermosetting polyester resins.
28. The polybutylene terephthalate composition according to Embodiment 10, wherein the sizing agent is selected from polyurethane resins and polyester resins, particularly thermosetting polyester resins.
29. The polybutylene terephthalate composition according to Embodiment 11, wherein the sizing agent is selected from polyurethane resins and polyester resins, particularly thermosetting polyester resins.
30. The polybutylene terephthalate composition according to Embodiment 12, wherein the sizing agent is selected from polyurethane resins and polyester resins, particularly thermosetting polyester resins.
31. The polybutylene terephthalate composition according to Embodiment 13, wherein the sizing agent is selected from polyurethane resins and polyester resins, particularly thermosetting polyester resins.
32. The polybutylene terephthalate composition according to Embodiment 14, wherein the sizing agent is selected from polyurethane resins and polyester resins, particularly thermosetting polyester resins.
33. The polybutylene terephthalate composition according to Embodiment 15, wherein the sizing agent is selected from polyurethane resins and polyester resins, particularly thermosetting polyester resins.
34. The polybutylene terephthalate composition according to Embodiment 16, wherein the sizing agent is selected from polyurethane resins and polyester resins, particularly thermosetting polyester resins.
35. The polybutylene terephthalate composition according to Embodiment 17, wherein the sizing agent is selected from polyurethane resins and polyester resins, particularly thermosetting polyester resins.
36. The polybutylene terephthalate composition according to Embodiment 18, wherein the sizing agent is selected from polyurethane resins and polyester resins, particularly thermosetting polyester resins.
37. The polybutylene terephthalate composition according to any of preceding Embodiments, wherein the at least one carbon fiber has a mean diameter of 5 to 30 µm, preferably 5 to 20 µm, more preferably 5 to 15 µm, and a length of 3 to 20 mm, preferably 3 to 15 mm, more preferably 5 to 10 mm.
38. The polybutylene terephthalate composition according to Embodiment 37, wherein the at least one carbon fiber has an aspect ratio of 270 to 4,000, particularly 400 to 2000.
39. The polybutylene terephthalate composition according to any of preceding Embodiments, wherein the at least one carbon fiber (B) is present in an amount of 20 to 40 % by weight, particularly 25 to 40 % by weight, based on the total weight of the polybutylene terephthalate composition.
40. The polybutylene terephthalate composition according to any of preceding Embodiments, wherein the polybutylene terephthalate (A) is present in an amount of 50 to 75 % by weight, for example 50 to 70% by weight, particularly 50 to 65 % by weight, based on the total weight of the polybutylene terephthalate composition.
41. The polybutylene terephthalate composition according to any of preceding Embodiments, wherein the solid filler (C) is carbonaceous or metallic, preferably carbonaceous.
42. The polybutylene terephthalate composition according to any of preceding Embodiments, wherein the solid filler (C) comprises carbon black powders or flakes.
43. The polybutylene terephthalate composition according to any of preceding Embodiments, wherein the solid filler (C) is present in an amount of 0.1 to 20 % by weight, particularly 1 to 20 % by weight, preferably 5 to 20 % by weight, based on the total weight of the polybutylene terephthalate composition.
44. An EMI shielding article produced from the polybutylene terephthalate composition according to any of Embodiments 1 to 43.
45. The EMI shielding article according to Embodiment 44, which is selected from radome, IC chip housing or camera sensor housing.
46. The EMI shielding article according to Embodiment 44 or 45, which has an EMI shielding effectiveness of 35 dB or greater at 1GHz, for example 35 dB to 60 dB, particularly 35 to 55 dB.
47. The EMI shielding article according to any of Embodiments 44 to 46, which has a surface resistivity of 1 to 10 Ω/□.
48. Use of a carbon fiber as defined in any of Embodiments 1 to 38 in an EMI shielding polybutylene terephthalate composition.

### EXAMPLES

Aspects of the present invention are more fully illustrated by the following examples, which are set forth to illustrate certain aspects of the present invention and are not to be construed as limiting thereof.

Following materials and test methods were used in the Examples.

### Materials:

(A) PBT: Ultradur^{®} B2550, commercially available from BASF;
(B) Carbon Fibers (CF)
   CF1: AMOS CD70006-PUY, commercially available from AMOS COMPOSITES, with 2.5 wt% polyurethane sizing, carbonizing temperature of 1100 °C, and carbon content of 93 wt% before sizing;
   CF2: NPS CFEPU LC C-6, commercially available from Nippon Polymer Sangyo Co. LTD., with 1.5 wt% Epoxy + Urethane sizing, carbonizing temperature of 1300 °C, and carbon content of 93 wt% before sizing;
   CF3: IM-MLD300 G.U1, commercially available from Procotex Corporation SA, with 4 wt% polyurethane sizing, carbonizing temperature of 1800 °C, and carbon content of 92 wt% without sizing;
   CF4: ZOLTEK PX35 Chopped Fiber (Type-45), commercially available from ZOLTEK Corporation, with 2.8 wt% thermosetting polyester sizing, carbonizing temperature of 1300 °C, and carbon content of 95 wt% without sizing.
(C) Solid fillers
   Carbon black: ENSACO^{®} E260G, commercially available from Imerys Graphite & Carbon;
   Graphite: TIMREX 20*50, commercially available from Imerys Graphite & Carbon.
(E) Additives
   LOXIOL^{®} P 861/3.5, commercially available from Emery Oleochemicals;
   Irganox 1010, commercially available from BASF;
   Lotader AX 8900, commercially available from Arkema;
   Vikoflex 7190, commercially available from Arkema.

### Methods for Measurements:

1. EMI shielding efficiency was measured using a plate specimen with length of 150 mm, width of 150 mm and thickness of 2mm at 1 GHz by Keysight Microwave Network Analyzer N5242B-425 in accordance with ASTM D4935-99.
2. Surface resistance (Rs, Ω/□) was determined by applying two lines of silver paint over one surface of a specimen of (60x60x2mm) in a direction parallel to one side, with a length (L=60 mm) and a distance (d), measuring the resistance (R) with a multimeter with the probes on the middle point of each dried silver line, and calculated in accordance with Rs = R × Ud. The specimen is conditioned at 23 °C and 50% relative humidity (RH) for at least 4 hours before the measurement.
3. Tensile strength at break, elongation at break and tensile modulus were measured in accordance with ISO527-1-2012 using a specimen of type 1A.
4. Notched Charpy value was measured in accordance with IS0179-1/1eA-2010 at 23 °C.
5. Thermal conductivities in plane and through plane, were measured by LFA 467 HyperFlash^{®} from NETZSCH Analyzing & Testing in accordance with ASTM E1461-13.

### General procedure for preparing the EMI shielding test specimens

EMI shielding test specimens were prepared in accordance with the formulations as shown in Table 1. PBT and the additives were mixed together in a Turbula T50A high-speed stirrer and fed into a twin-screw extruder (Coperion ZSK18).The carbon fibers of 6mm(L)×7µm(D), and additional solid fillers when used were fed into the extruder at a downstream side feeder, and then melt-extruded with the zone temperatures ranging from 160 °C to 270 °C at a throughput of 8kg/h, and pelletized, thus obtaining a PBT composition in a pellet form.

The dried pellets of the PBT composition were processed in an injection molding machine (KM130CX, from Krauss Maffei) with a clamping force of 130T at melt temperatures of 265 °C to 275 °C to provide a test specimen.

The obtained test specimens were measured for the properties as described above. The test results and the formulations for the preparation of the test specimens are summarized in Table 1.

**Table 1**

| Component, wt% | EX.1 | EX.2 | EX.3 | EX.4 | EX.5 | EX.6 | Comp .1 | Comp .2 | Comp .3 | Comp .4 |
|---|---|---|---|---|---|---|---|---|---|---|
| PBT | 62.7 | 52.7 | 52.2 | 52.2 | 57.2 | 49.7 | 62.7 | 52.7 | 67.7 | 57.7 |
| CF1 | 30 | 40 | 30 | | 25 | 25 | | | | |
| CF2 | | | | | | | 30 | | 25 | 25 |
| CF3 | | | | | | | | 40 | | |
| CF4 | | | | 30 | | | | | | |
| Carbon black | | | 10.5 | 10.5 | 10.5 | 9 | | | | |
| Graphite | | | | | | 9 | | | | 10 |
| Loxiol P861/3.5 | 0.5 | 0.5 | 0.5 | 0.5 | 0.5 | 0.5 | 0.5 | 0.5 | 0.5 | 0.5 |
| Irganox 1010 | 0.3 | 0.3 | 0.3 | 0.3 | 0.3 | 0.3 | 0.3 | 0.3 | 0.3 | 0.3 |
| Lotader AX 8900 | 5 | 5 | 5 | 5 | 5 | 5 | 5 | 5 | 5 | 5 |
| Vikoflex 7190 | 1.5 | 1.5 | 1.5 | 1.5 | 1.5 | 1.5 | 1.5 | 1.5 | 1.5 | 1.5 |
| Total percentage | 100 | 100 | 100 | 100 | 100 | 100 | 100 | 100 | 100 | 100 |
| | | | | | | | | | | |
| EMI shielding efficiency, @ 1GHz, dB | 37 | 40 | 46 | 53 | 41 | 42 | 24 | 30 | 23 | 26 |
| Surface resistivity, Ohm/sq | 9.6 | 4 | 3.5 | 1.4 | 3.2 | 2 | 24 | 9.6 | 23.5 | 14.5 |
| Tensile Modulus, M Pa | 20200 | 26500 | 22100 | 22500 | 18200 | 19800 | 20700 | 28800 | 18400 | 20500 |
| Tensile strength at break, MPa | 139 | 168 | 153 | 151 | 145 | 115 | 153 | 162 | 153 | 121 |
| Elongation at break, % | 1.17 | 1.22 | 1.51 | 1.15 | 1.94 | 0.96 | 1.43 | 0.86 | 1.8 | 0.94 |
| Charpy, Notched @ 23°C, KJ/m² | 5.5 | 6.1 | 5.9 | 6.9 | 5.5 | 6 | 7.5 | 8.2 | 7.4 | 6.6 |
| Thermal conductivity, In plane/ through plane, W/m*K | 0.9/ 0.33 | | | | 1.09/ 0.44 | 2.01/ 0.61 | | | | |

| | | | | | | | | | | |
|---|---|---|---|---|---|---|---|---|---|---|
| EX.: Example; Comp.: Comparative Example | | | | | | | | | | |

It can be seen that the specimens prepared from the PBT composition according to the present invention show higher EMI shielding efficiency and lower surface resistivity, in comparison to the specimens prepared from the PBT composition comprising carbon fibers having been treated with a sizing composition comprising epoxy resin and from the PBT composition comprising carbon fibers having a carbon content of 92%.

## Claims

1. A polybutylene terephthalate composition, comprising
(A) 45 to 75 % by weight of polybutylene terephthalate,
(B) 20 to 45 % by weight of at least one carbon fiber,
(C) 0 to 20 % by weight of at least one solid filler other than the carbon fiber (B), and
(D) 0 to 30 % by weight of at least one thermoplastic polyester other than polybutylene terephthalate,
each being based on the total weight of the polybutylene terephthalate composition, wherein the at least one carbon fiber has a carbon content of 93% by weight or greater, and comprises a sizing agent other than epoxy sizing agent.

2. The polybutylene terephthalate composition according to claim 1, wherein the at least one carbon fiber is selected from polyacrylonitrile-based carbon fibers, pitch-based carbon fibers or rayon-based carbon fibers, particularly polyacrylonitrile-based carbon fibers.

3. The polybutylene terephthalate composition according to any of preceding claims, wherein the at least one carbon fiber is produced via carbonation at a temperature of 1300 °C or lower, for example in the range of 1100 to 1300 °C.

4. The polybutylene terephthalate composition according to any of preceding claims, wherein the fiber has a carbon content in the range of 93 to 95% by weight.

5. The polybutylene terephthalate composition according to any of preceding claims, wherein the sizing agent is selected from polyurethane resins and polyester resins, particularly polyester resins.

6. The polybutylene terephthalate composition according to any of preceding claims, wherein the at least one carbon fiber has a mean diameter of 5 to 30 µm, preferably 5 to 20 µm, more preferably 5 to 15 µm, and a length of 3 to 20 mm, preferably 3 to 15 mm, more preferably 5 to 10 mm, and wherein the at least one carbon fiber has an aspect ratio of preferably 270 to 4,000, particularly 400 to 2000.

7. The polybutylene terephthalate composition according to any of preceding claims, wherein one, two or all three of the following conditions (i), (ii) and/or (iii) apply:
(i) the polybutylene terephthalate (A) is present in an amount of 50 to 75 % by weight, for example 50 to 70% by weight, particularly 50 to 65 % by weight, based on the total weight of the polybutylene terephthalate composition;
(ii) the at least one carbon fiber (B) is present in an amount of 20 to 40 % by weight, particularly 25 to 40 % by weight, based on the total weight of the polybutylene terephthalate composition; and/or
(iii) the solid filler (C) is present in an amount of 0.1 to 20 % by weight, particularly 1 to 20 % by weight, preferably 5 to 20 % by weight, based on the total weight of the polybutylene terephthalate composition.

8. The polybutylene terephthalate composition according to any of preceding claims, wherein the solid filler (C) is carbonaceous or metallic, preferably carbonaceous.

9. The polybutylene terephthalate composition according to any of preceding claims, wherein the solid filler (C) comprises carbon black powders or flakes.

10. An EMI shielding article produced from the polybutylene terephthalate composition according to any of claims 1 to 9.

11. The EMI shielding article according to claim 10, which is selected from radome, IC chip housing or camera sensor housing.

12. A radome component produced from the polybutylene terephthalate composition according to any of claims 1 to 9; where the radome is preferably vehicle radome.

13. The EMI shielding article according to claim 10 or 11 or the radome component according to claim 12, which has an EMI shielding effectiveness of 35 dB or greater at 1GHz, for example 35 dB to 60 dB, particularly 35 to 55 dB.

14. The EMI shielding article according to any of claims 10, 11 or 13 or the radome component according to any of claims 12 or 13, which has a surface resistivity of 1 to 10 Ω/□.

15. Use of a carbon fiber as defined in any of claims 1 to 6 in an EMI shielding polybutylene terephthalate composition.

## Patentansprüche

1. Polybutylenterephthalatzusammensetzung umfassend
(A) 45 bis 75 Gew.-% Polybutylenterephthalat,
(B) 20 bis 45 Gew.-% an wenigstens einer Kohlenstofffaser,
(C) 0 bis 20 Gew.-% an wenigstens einem festen Füllstoff, der von der Kohlenstofffaser (B) verschieden ist, und
(D) 0 bis 30 Gew.-% an wenigstens einem thermoplastischen Polyester, der von Polybutylenterephthalat verschieden ist,
jeweils bezogen auf das Gesamtgewicht der Polybutylenterephthalatzusammensetzung, wobei die wenigstens eine Kohlenstofffaser einen Kohlenstoffgehalt von 93 Gew.-% oder mehr aufweist und ein von Epoxy-Leimungsmittel verschiedenes Leimungsmittel umfasst.

2. Polybutylenterephthalatzusammensetzung nach Anspruch 1, wobei die wenigstens eine Kohlenstofffaser ausgewählt ist aus Kohlenstofffasern auf Polyacrylnitrilbasis, Kohlenstofffasern auf Pechbasis und Kohlenstofffasern auf Rayonbasis, insbesondere Kohlenstofffasern auf Polyacrylnitrilbasis.

3. Polybutylenterephthalatzusammensetzung nach einem der vorstehenden Ansprüche, wobei die wenigstens eine Kohlenstofffaser durch Carbonisierung bei einer Temperatur von 1300 °C oder weniger, beispielsweise in dem Bereich von 1100 bis 1300 °C, hergestellt ist.

4. Polybutylenterephthalatzusammensetzung nach einem der vorstehenden Ansprüche, wobei die Faser einen Kohlenstoffgehalt in dem Bereich von 93 bis 95 Gew.-% aufweist.

5. Polybutylenterephthalatzusammensetzung nach einem der vorstehenden Ansprüche, wobei das Leimungsmittel ausgewählt ist aus Polyurethanharzen und Polyesterharzen, insbesondere Polyesterharzen.

6. Polybutylenterephthalatzusammensetzung nach einem der vorstehenden Ansprüche, wobei die wenigstens eine Kohlenstofffaser einen mittleren Durchmesser von 5 bis 30 um, vorzugsweise 5 bis 20 um, bevorzugter 5 bis 15 um, und eine Länge von 3 bis 20 mm, vorzugsweise 3 bis 15 mm, bevorzugter 5 bis 10 mm, aufweist und wobei die wenigstens eine Kohlenstofffaser ein Aspektverhältnis von vorzugsweise 270 bis 4.000, insbesondere 400 bis 2000, aufweist.

7. Polybutylenterephthalatzusammensetzung nach einem der vorstehenden Ansprüche, wobei eine, zwei oder alle drei der folgenden Bedingungen (i), (ii) und/oder (iii) zutreffen:
(i) das Polybutylenterephthalat (A) ist in einer Menge von 50 bis 75 Gew.-%, beispielsweise 50 bis 70 Gew.-%, insbesondere 50 bis 65 Gew.-%, bezogen auf das Gesamtgewicht der Polybutylenterephthalatzusammensetzung vorhanden;
(ii) die wenigstens eine Kohlenstofffaser (B) ist in einer Menge von 20 bis 40 Gew.-%, insbesondere 25 bis 40 Gew.-%, bezogen auf das Gesamtgewicht der Polybutylenterephthalatzusammensetzung vorhanden; und/oder
(iii) der feste Füllstoff (C) ist in einer Menge von 0,1 bis 20 Gew.-%, insbesondere 1 bis 20 Gew.-%, vorzugsweise 5 bis 20 Gew.-%, bezogen auf das Gesamtgewicht der Polybutylenterephthalatzusammensetzung vorhanden.

8. Polybutylenterephthalatzusammensetzung nach einem der vorstehenden Ansprüche, wobei der feste Füllstoff (C) kohlenstoffhaltig oder metallisch, vorzugsweise kohlenstoffhaltig, ist.

9. Polybutylenterephthalatzusammensetzung nach einem der vorstehenden Ansprüche, wobei der feste Füllstoff (C) Rußpulver oder -flocken umfasst.

10. EMI-Abschirmgegenstand, hergestellt aus der Polybutylenterephthalatzusammensetzung nach einem der Ansprüche 1 bis 9.

11. EMI-Abschirmgegenstand nach Anspruch 10 ausgewählt aus Radom, IC-Chipgehäuse und Kamerasensorgehäuse.

12. Radomkomponente, hergestellt aus der Polybutylenterephthalatzusammensetzung nach einem der Ansprüche 1 bis 9, wobei das Radom vorzugsweise Fahrzeugradom ist.

13. EMI-Abschirmgegenstand nach Anspruch 10 oder 11 oder Radomkomponente nach Anspruch 12, der/die eine EMI-Abschirmwirkung von 35 dB oder mehr bei 1 GHz, beispielsweise 35 dB bis 60 dB, insbesondere 35 bis 55 dB, aufweist.

14. EMI-Abschirmgegenstand nach einem der Ansprüche 10, 11 oder 13 oder Radomkomponente nach einem der Ansprüche 12 oder 13, der einen spezifischen Oberflächenwiderstand von 1 bis 10 Ω/□ aufweist.

15. Verwendung einer Kohlenstofffaser nach einem der Ansprüche 1 bis 6 in einer EMI-abschirmenden Polybutylenterephthalatzusammensetzung.

## Revendications

1. Composition de poly(téréphtalate de butylène), comprenant
(A) 45 à 75 % en poids de poly(téréphtalate de butylène),
(B) 20 à 45 % en poids d'au moins une fibre de carbone,
(C) 0 à 20 % en poids d'au moins une charge solide autre que la fibre de carbone (B), et
(D) 0 à 30 % en poids d'au moins un polyester thermoplastique autre qu'un poly(téréphtalate de butylène),
chacun étant basé sur le poids total de la composition de poly(téréphtalate de butylène), dans laquelle l'au moins une fibre de carbone a une teneur en carbone de 93 % en poids ou plus, et comprend un agent d'encollage autre qu'un agent d'encollage de type époxy.

2. Composition de poly(téréphtalate de butylène) selon la revendication 1, dans laquelle l'au moins une fibre de carbone est choisie parmi des fibres de carbone à base de polyacrylonitrile, des fibres de carbone à base de brai ou des fibres de carbone à base de rayonne, en particulier des fibres de carbone à base de polyacrylonitrile.

3. Composition de poly(téréphtalate de butylène) selon l'une quelconque des revendications précédentes, dans laquelle l'au moins une fibre de carbone est produite par carbonatation à une température de 1 300 °C ou moins, par exemple dans la plage de 1 100 à 1 300 °C.

4. Composition de poly(téréphtalate de butylène) selon l'une quelconque des revendications précédentes, dans laquelle la fibre a une teneur en carbone dans la plage de 93 à 95 % en poids.

5. Composition de poly(téréphtalate de butylène) selon l'une quelconque des revendications précédentes, dans laquelle l'agent d'encollage est choisi parmi les résines de polyuréthane et les résines de polyester, en particulier les résines de polyester.

6. Composition de poly(téréphtalate de butylène) selon l'une quelconque des revendications précédentes, dans laquelle l'au moins une fibre de carbone a un diamètre moyen de 5 à 30 um, de préférence de 5 à 20 um, plus préférablement de 5 à 15 um, et une longueur de 3 à 20 mm, de préférence de 3 à 15 mm, plus préférablement de 5 à 10 mm, et dans laquelle l'au moins une fibre de carbone a un rapport d'aspect de préférence de 270 à 4 000, en particulier de 400 à 2 000.

7. Composition de poly(téréphtalate de butylène) selon l'une quelconque des revendications précédentes, dans laquelle une, deux ou les trois conditions suivantes (i), (ii) et/ou (iii) s'appliquent :
(i) le poly(téréphtalate de butylène) (A) est présent en une quantité de 50 à 75 % en poids, par exemple de 50 à 70 % en poids, en particulier de 50 à 65 % en poids, par rapport au poids total de la composition de poly(téréphtalate de butylène) ;
(ii) l'au moins une fibre de carbone (B) est présente en une quantité de 20 à 40 % en poids, en particulier de 25 à 40 % en poids, par rapport au poids total de la composition de poly(téréphtalate de butylène) ; et/ou
(iii) la charge solide (C) est présente en une quantité de 0,1 à 20 % en poids, en particulier de 1 à 20 % en poids, de préférence de 5 à 20 % en poids, par rapport au poids total de la composition de poly(téréphtalate de butylène).

8. Composition de poly(téréphtalate de butylène) selon l'une quelconque des revendications précédentes, dans laquelle la charge solide (C) est carbonée ou métallique, de préférence carbonée.

9. Composition de poly(téréphtalate de butylène) selon l'une quelconque des revendications précédentes, dans laquelle la charge solide (C) comprend des poudres ou des flocons de noir de carbone.

10. Article de blindage contre EMI produit à partir de la composition de poly(téréphtalate de butylène) selon l'une quelconque des revendications 1 à 9.

11. Article de blindage contre EMI selon la revendication 10, qui est choisi parmi un radôme, un logement de puce de IC ou un logement de capteur de caméra.

12. Composant radôme produit à partir de la composition de poly(téréphtalate de butylène) selon l'une quelconque des revendications 1 à 9, dans lequel le radôme est de préférence un radôme de véhicule.

13. Article de blindage contre EMI selon la revendication 10 ou 11 ou composant radôme selon la revendication 12, qui a une efficacité de blindage contre EMI de 35 dB ou supérieure à 1 GHz, par exemple de 35 dB à 60 dB, en particulier de 35 à 55 dB.

14. Article de blindage contre EMI selon l'une quelconque des revendications 10, 11 ou 13 ou composant radôme selon l'une quelconque des revendications 12 ou 13, qui a une résistivité de surface de 1 à 10 Ω/□.

15. Utilisation d'une fibre de carbone telle que définie dans l'une quelconque des revendications 1 à 6 dans une composition de poly(téréphtalate de butylène) de blindage contre EMI.
